# EUROPÄISCHE PATENTSCHRIFT

(11) **EP 0 261 370 B1**
(45) Veröffentlichungstag und Bekanntmachung des Hinweises auf die Patenterteilung: **10.03.1993**
(21) Anmeldenummer: 87111569.7
(22) Anmeldetag: 10.08.1987
(51) Int. Cl.: H01L 27/04

(54) **Integrierte Schaltung mit "Latch-up" Schutzschaltung in komplementärer MOS Schaltungstechnik**
Integrated circuit having latch-up protection circuit fabricated by complementary MOS technology
Circuit integré ayant un circuit anti virrouillage fabriqué en technologie MOS complémentaire

(30) Priorität: 26.09.1986 DE 3632828
(43) Veröffentlichungstag der Anmeldung: 30.03.1988
(73) Patentinhaber: SIEMENS AKTIENGESELLSCHAFT, 80333 München (DE)
(72) Erfinder: Winnerl, Josef, Dr., D-8300 Landshut (DE); Reczek, Werner, D-8000 München 90 (DE)

(56) Entgegenhaltungen:
- EP-A- 0 142 258
- EP-A- 0 175 152
- GB-A- 2 103 897
- US-A- 4 303 958
- US-A- 4 353 105
- IEEE, 1985, Seiten 504-508, New York, US; D. TACKACS et al.: "Static and transient latch-up hardness in N-well CMOS with on-chip substrate BIAS generator"

## Beschreibung

Die Erfindung bezieht sich auf eine integrierte Schaltung mit "Latch-up" Schutzschaltung in komplementärer MOS Schaltungstechnik nach den gleichlautenden Oberbegriffen der Patentansprüche 1 und 6.

Bei integrierten Schaltungen dieser Art in komplementärer MOS-Technologie liegt das Halbleitersubstrat nicht auf dem Massepotential der integrierten Schaltung, sondern es wird durch einen Substratvorspannungsgenerator aufgeladen. Die Substratvorspannung des Substratvorspannungsgenerators verringert die Transistor- und Sperrschichtkapazitäten und verbessert die Schaltgeschwindigkeit. Bei einem Halbleitersubstrat aus p-leitendem Material, das mit einer eingefügten n-leitenden wannenförmigen Halbleiterzone versehen ist, handelt es sich dabei um eine negative Substratvorspannung von etwa -2 bis -3 Volt. Die Sourcegebiete von Feldeffekttransistoren, die außerhalb der wannenförmigen Halbleiterzone auf dem Halbleitersubstrat vorgesehen sind, sind hierbei auf das Massepotential gelegt.

Im Moment des Einschaltens der positiven Versorgungsspannung befindet sich das betrachtete p-leitende Halbleitersubstrat zunächst in einem Zustand des "floating", in dem es von äußeren Potentialen freigeschaltet ist.

Dieser Zustand wird durch das Wirksamwerden des Substratvorspannungsgenerators beendet. Die Zeitspanne zwischen dem Einschalten der Versorgungsspannung und dem Wirksamwerden des Substratvorspannungsgenerators wird im wesentlichen durch die Taktfrequenz, vorhandene Koppelkapazitäten und die vorhandene kapazitive Last beeinflußt. In der Zeit des "floating" kann das Halbleitersubstrat über die Sperrschichtkapazitäten, die einerseits zwischen der wannenförmigen Halbleiterzone und dem Substrat und andererseits zwischen den mit dem Massepotential belegten Sourcegebieten und dem Substrat vorhanden sind, vorübergehend auf eine positive Vorspannung aufgeladen werden, die erst beim Wirksamwerden des Substratvorspannungsgenerators wieder abgebaut und durch die sich am Ausgang desselben allmählich aufbauende negative Substratvorspannung ersetzt wird. Aber auch im Betrieb der integrierten Schaltung können größere Ströme, die vom Halbleitersubstrat über den Substratvorspannungsgenerator zu einem auf Massepotential liegenden Anschluß des letzteren abgeleitet werden, durch den Spannungsabfall am Innenwiderstand des Substratvorspannungsgenerators zu einer positiven Vorspannung des Halbleitersubstrats führen. Positive Vorspannungen stellen aber ein hohes Sicherheitsrisiko für die integrierte Schaltung dar, da ein "Latch-up"-Effekt ausgelöst werden kann, der im allgemeinen den Ausfall der integrierten Schaltung bedeutet.

Zum Verständnis des "Latch-up"-Effekts kann man davon ausgehen, daß zwischen einem Anschluß eines in der wannenförmigen Halbleiterzone liegenden Feldeffekttransistors des ersten Kanaltyps und einem Anschluß eines außerhalb dieser Zone auf dem Halbleitersubstrat plazierten Feldeffekttransistor des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmige Halbleiterzone die zweite, das Halbleitersubstrat die dritte und das eine Anschlußgebiet des letzten Transistors die vierte Halbleiterschicht bilden. Aufgrund dieses Aufbaus gibt ergeben sich ein parasitärer bipolarer pnp- und ein npn-Transistor. Der Kollektor des pnp-Transistors entspricht der Basis des npn-Transistors und die Basis des pnp-Transistors dem Kollektor des npn-Transistors. Diese Struktur bildet eine Vierschichtdiode pnpn wie bei einem Thyristor. Bei einer positiven Vorspannung des Halbleitersubstrats kann der pn-Übergang zwischen der dritten und vierten Halbleiterschicht soweit in Durchlaßrichtung vorgespannt werden, daß zwischen den genannten Transistoranschlüssen ein Strompfad entsteht, der auf eine parasitäre Thyristorwirkung innerhalb dieser Vierschichtenstruktur zurückzuführen ist. Der Strompfad bleibt dann auch nach einem Abbau der positiven Substratvorspannung bestehen und kann die integrierte Schaltung thermisch überlasten.

Es ist bekannt, daß zur Verringerung der Transistor- und Sperrschichtkapazitäten eine negative Substratvorspannung in der NMOS-Technik verwendet wird, die über einen sogenannten Substratvorspannungsgenerator auf der integrierten Schaltung erzeugt wird (siehe Buchreihe Halbleiterelektronik, 14, H. Weiß, K. Horninger "Integrierte MOS-Schaltungen", Seiten 247 bis 248). Der "Latch-up"-Effekt bei positiven Halbleitersubstratspannungen ist ebenfalls in diesem Fachbuch auf den Seiten 111 bis 112 beschrieben. Als Abhilfe werden hier eine Änderung der Technologie (Dotierungsprofile) oder Maßnahmen beim Entwurf (Wannenabstände) vorgeschlagen.

Aus der Veröffentlichung D. Takacs et al., "Static and transient latch-up hardness in n-well CMOS with on-chip substrate bias generator", IEDM 85, Technical Digest, Seite 504 bis 508 und aus der europäischen Anmeldeschrift EP-A-0 142 258 ist eine integrierte Schaltung in komplementärer Schaltungstechnik mit Feldeffekttransistoren unterschiedlicher Kanaltypen, von denen wenigstens ein erster in einem p-leitenden Halbleitersubstrat und wenigstens ein zweiter in einer im Halbleitersubstrat vorgesehenen n-leitenden wannenförmigen Halbleiterzone angeordnet sind, wobei die Halbleiterzone mit einer positiven Versorgungsspannung beschaltet ist, wobei ein Anschlußgebiet wenigstens eines ersten Feldeffekttransistors mit einem Massepotential angeschlossen ist, wobei das Halbleitersubstrat mit dem Ausgang eines eine negative Substratvorspannung erzeugenden Substratvorspannungsgenerators verbunden ist, dem das Massepotential und die Versorgungsspannung zugeführt werden, wobei der Ausgang des Substratvorspannungsgenerators über einen dritten, n-Kanal-Feldeffekttransistor mit einem auf Massepotential liegenden Schaltungspunkt verbunden ist, und wobei der Gateanschluß des dritten Feldeffekttransistors mit dem Substratvorspannungsanschluß verbunden ist, bekannt.

Es wird hierin eine Klemmschaltung vorgeschlagen, die einen "Latch-up"-Effekt dadurch verhindert, indem das Halbleitersubstratpotential auf einen Wert begrenzt wird, der nicht ausreicht, die parasitären Bipolartransistoren im Halbleitersubstrat zu aktivieren. Die Klemmschaltung muß dazu die hohen kapazitiven Ladeströme nach Masse abführen.

Durch die oben angegebene Klemmschaltung wird prinzipiell nicht die Möglichkeit der positiven Aufladung des Halbleitersubstrats ausgeschlossen, sondern es werden lediglich seine Auswirkungen dadurch kompensiert, daß, falls eine positive Aufladung des Halbleitersubstrats erfolgt ist, eine niederohmige Masseverbindung die positive Aufladung wieder abbaut.

Der Erfindung liegt die Aufgabe zugrunde, eine Schaltung der eingangs genannten Art anzugeben, bei der das Auftreten von "Latch-up"-Effekten weitgehend vermieden wird. Das wird erfindungsgemäß durch die Ausbildungen der Schaltung nach den kennzeichnenden Teilen der Patentansprüche 1 und 6 erreicht.

Die Patentansprüche 2 bis 5 und 7 bis 10 sind auf bevorzugte Ausgestaltungen und Weiterbildungen der Erfindung gerichtet. Der Patentanspruch 11 betrifft eine bevorzugte Anwendung der Erfindung.

Der mit der Erfindung erzielbare Vorteil liegt insbesondere darin, daß eine unerwünscht hohe Aufladung des Halbleitersubstrats, die einen "Latch-up"-Effekt auslösen kann, mit einfachen Mitteln auf einen Wert begrenzt wird, der diese Gefahr ausschließt.

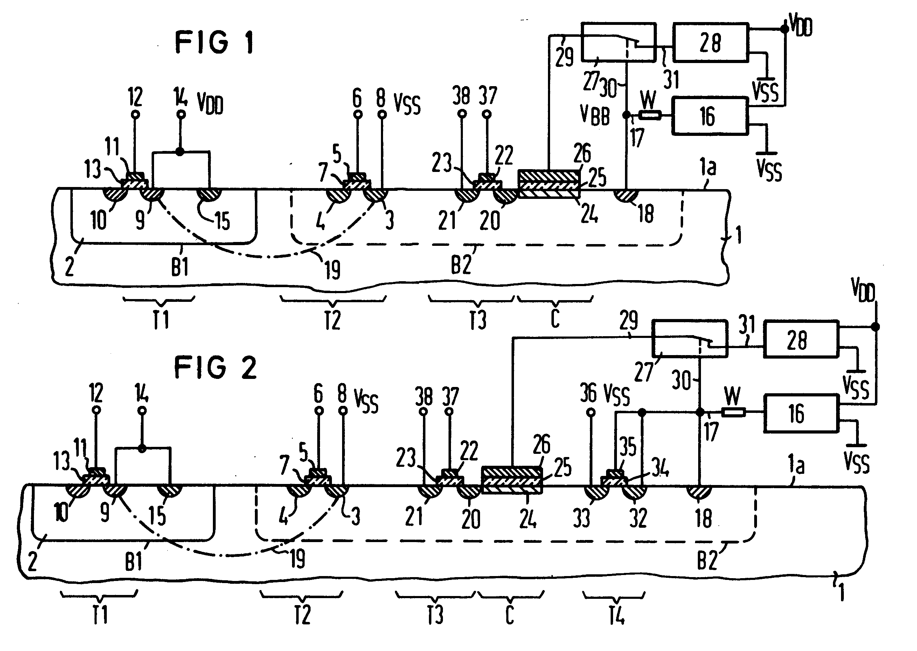

Zwei Ausführungsbeispiele der Erfindung sind in den Zeichnungen in Figur 1 und 2 dargestellt und werden im folgenden näher beschrieben. Es zeigt
- Figur 1: eine integrierte Schaltung mit "Latch-up" Schutzschaltung in CMOS Schaltungstechnik mit einer Eintransistorspeicherzelle,
- Figur 2: eine integrierte Schaltung mit "Latch-up" Schutzschaltung wie Figur 1, zusätzlich ausgestattet mit einer Klemmschaltung,
- Figur 3: eine Prinzipschaltung einer "Latch-up" Schutzschaltung,
- Figur 4: ein Ausführungsbeispiel für eine "Latch-up" Schutzschaltung.

In Figur 1 ist eine erfindungsgemäße integrierte Schaltung mit "Latch-up" Schutzschaltung dargestellt, die auf einem Halbleitersubstrat 1 aus dotiertem Halbleitermaterial, zum Beispiel p-leitendem Silizium, aufgebaut ist. Das Halbleitersubstrat 1 weist eine n-leitende, wannenförmige Halbleiterzone 2 auf, die sich bis zur Grenzfläche 1a des Halbleitersubstrats 1 hin erstreckt. Außerhalb der Halbleiterzone 2 sind in das Halbleitersubstrat n⁺-dotierte Halbleitergebiete 3, 4, 20 und 21 eingefügt, die die Source- und Draingebiete zweier n-Kanal-Feldeffekttransistoren T2 und T3 bilden. Der Kondensator C, der beliebig ausgebildet sein kann (beispielsweise als "stacked capacitor" oder als "trench capacitor"), besteht in diesem Falle aus einer planaren Dielektrikumschicht 25, einer planaren Polysiliziumschicht 26 und einer planaren n dotierten Schicht 24 und bildet zusammen mit dem n-Kanal-Feldeffekttransistor T3 eine Eintransistorspeicherzelle, in die Informationen abgelegt oder aus der Informationen ausgelesen werden können. Der zwischen 3 und 4 bzw. 20 und 21 liegende Kanalbereich wird von einem Gate 5 bzw. 22 überdeckt, das mit einem Anschluß 6 bzw. 37 versehen ist und durch eine dünne elektrisch isolierende Schicht 7 bzw. 23, z.B. aus SiO₂, von der Grenzfläche 1a getrennt ist. Das Draingebiet 21 ist mit dem Anschluß 38 verbunden, während das Sourcegebiet 3 mit dem auf Massepotential V_{SS} liegenden Anschluß 8 verschaltet ist. Weiterhin sind in die Halbleiterzone 2 p⁺-dotierte Gebiete 9 und 10 eingefügt, welche das Source- und das Draingebiet eines p-Kanal-Feldeffekttransistors T1 darstellen. Der zwischen den Gebieten 9 und 10 liegende Kanalbereich wird von einem Gate 11 überdeckt, das mit einem Anschluß 12 versehen ist und durch eine dünne elektrisch isolierende Schicht 13, zum Beispiel aus SiO₂, von der Grenzflüche 1a getrennt ist. Das Sourcegebiet 9 vom Feldeffekttransistor T1 ist mit einem Anschluß 14 verbunden, der mit einem Versorgungspotential V_{DD} beschaltet ist. Über ein n⁺-dotiertes Kontaktgebiet 15, das mit dem Anschluß 14 in Verbindung steht, liegt die Halbleiterzone 2 auf der Versorgungsspannung V_{DD}.

Weiterhin ist ein Substratvorspannungsgenerator 16 vorgesehen, der eine negative Substratvorspannung von zum Beispiel -2 bis -3 Volt erzeugt und seinerseits an Masse V_{SS} und an die Versorgungsspannung V_{DD} angeschlossen ist. Der Ausgang 17 des Substratvorspannungsgenerators ist über den Eingang 30 mit der Latch-up-Schutzschaltung 27 und mit einem p⁺-dotierten Substratspannungsanschluß 18 verbunden, der in das Halbleitersubstrat 1 eingefügt ist. Damit befindet sich das Halbleitersubstrat 1 auf der durch 16 erzeugten negativen Substratvorspannung V_{BB}, während sich die Sourcegebiete, zum Beispiel 3, der im Halbleitersubstrat 1 befindlichen Transistoren, zum Beispiel T2, auf Massepotential V_{SS} befinden. Hierdurch wird unter anderem erreicht, daß die Sperrschichtkapazitäten der Drain- und Sourcegebiete der im Halbleitersubstrat 1 angeordneten Transistoren verkleinert werden. Zur Vermeidung eines " Latch-up"-Effekts, der entlang der gestrichelten Linie 19 liegenden Vierschichtstruktur 3, 1, 2 und 9 zwischen den Anschlüssen 8 und 14 auftreten könnte, werden die kapazitiven Ladeströme des Kondensators C durch die elektronische Schutzschaltung 27 auf Werte vermindert, die nicht ausreichen, das Substrat soweit positiv aufzuladen, daß ein "Latch-up" ausgelöst wird. In der elektronischen Schutzschaltung 27 wird in Abhängigkeit von einer Signalgröße am Eingang 30 der Eingang 31 elektrisch mit dem Ausgang 29, der an einer Kondensatorfläche 26 des Kondensators C angeschlossen ist, verbunden. Der Eingang 31 ist an einen Vorspannungsgenerator 28 für den Kondensator angeschlossen, der seinerseits mit Masse V_{SS} und mit der Versorgungsspannung V_{DD} verbunden ist. Die Ausgangsspannung des Vorspannungsgenerators kann beispielsweise die Hälfte der Versorgungsspannung, also V_{DD}/2 betragen. Der Eingang 30 der elektronischen Schutzschaltung ist gleichzeitig mit dem Ausgang 17 des Substratvorspannungsgenerators 16 und mit dem p⁺-dotierten Substratvorspannungsanschluß 18 verbunden. Bei Spannungen V_{BB}, die größer sind als eine interne Referenzspannung, bewirkt die elektronische Schutzschaltung eine Unterbrechung zwischen dem Eingang 31 und dem Ausgang 29. Dies bedeutet, daß bei positivem Substratpotential die kapazitiven Ladeströme vom Vorspannungsgenerator 28 auf den Kondensator C unterbunden werden. Dies tritt beispielsweise dann ein, wenn beim Einschalten der Versorgungsspannung V_{DD} das Halbleitersubstrat 1 durch die kapazitiven Ladeströme auf eine positive Vorspannung angehoben wird, solange der Substratvorspannungsgenerator 16 noch nicht seine volle negative Vorspannung liefert. Im Normalbetrieb bzw. bei negativer Substratvorspannung liegt die Kondensatorfläche 26 niederohmig über die elektronische Schutzschaltung 27 am Vorspannungsgenerator 28 für den Kondensator.

In Figur 2 ist ein zweites Ausführungsbeispiel der Erfindung dargestellt, das sich von Figur 1 durch eine zusätzliche Klemmschaltung unterscheidet. Der Ausgang 17 des Substratvorspannungsgenerators 16 ist hierzu über einen elektronischen Schalter, hier ein Feldeffekttransistor T4, mit einem Schaltungspunkt verbunden, der sich auf Massepotential V_{SS} befindet. Beim dargestellten Ausführungsbeispiel handelt es sich bei diesem Schaltungspunkt um den Anschluß 36. Im einzelnen ist der Ausgang 17 bei der Anordnung nach Figur 2 mit einem n⁺ -dotierten Halbleitergebiet 32 verbunden, das in das Halbleitersubstrat 1 eingefügt ist. Ein weiteres n⁺-dotiertes, in das Halbleitersubstrat 1 eingefügtes Halbleitergebiet 33 ist mit dem auf Massepotential V_{SS} liegenden Schaltungspunkt, das heißt mit dem Anschluß 36 verbunden. Der zwischen den Gebieten 32 und 33 liegende Bereich des Halbleitersubstrats 1 ist von einem Gate 35 überdeckt, das durch eine dünne elektrisch isolierende Schicht 34, zum Beispiel aus SiO₂, von der Grenzfläche 1a getrennt ist. Die Gebiete 32 und 33 bilden zusammen mit den Teilen 34 und einen n-Kanal-Feldeffektschalttransistor T4. Die Ansteuerung von T4 erfolgt über den Knoten 17.

Der Schalttransistor 32 bis 35 in Figur 2 soll eine niedrige Einsatzspannung haben, die kleiner ist als die Durchlaßspannung des pn-Übergangs zwischen 1 und 3. Das ist in der herkömmlichen Weise zum Beispiel dadurch zu erreichen, daß der zwischen den Gebieten 32 und 33 liegende Bereich des Halbleitersubstrats 1 außer der Grunddotierung, die zum Beispiel 10¹⁵cm⁻³ beträgt, keine zusätzliche Dotierung aufweist, während die Kanalbereiche der übrigen Feldeffekttransistoren, zum Beispiel T2, in der Nähe der Grenzfläche 1a mit einer zusätzlichen, die Grunddotierung verstärkenden Dotierung versehen sind, die zweckmäßigerweise im Wege einer Implantation mit einer Dosis von etwa 10¹²cm⁻² eingebracht wird. Sind in der verwendeten Herstellungstechnik zwei verschiedene Isolierschichtdicken verfügbar, so wird für 34 zweckmäßigerweise die kleinere verwendet, die zum Beispiel 15 nm beträgt, während für die Schicht 7 und 13 eine Dicke von etwa 20 bis 25 nm gewählt wird. Liegt das Halbleitersubstrat 1 auf einer positiven Vorspannung, was beispielsweise beim Anschalten der Versorgungsspannung V_{DD} auftritt, wenn der Substratvorspannungsgenerator 16 noch nicht die volle negative Spannung hat, wie dies in Figur 1 schon erläutert wurde, so ist auch das Gate 35 entsprechend positiv vorgespannt, was bei Überschreiten der niedrigen Einsatzspannung dazu führt, daß der Schalttransistor 32 bis 35 leitet. Damit wird dann die Spannung am Knoten 17 auf den Wert der niedrigen Einsatzspannung begrenzt.

Während die elektronische Schutzschaltung durch eine Unterbrechung des kapazitiven Ladestromes des Kondensators C eine positive Aufladung durch diesen Ladestrom am Halbleitersubstrat 1 verhindert, wirkt die zusätzliche Klemmschaltung allen übrigen Möglichkeiten der positiven Substrataufladung entgegen. Ergeben sich beispielsweise im Betrieb große Ströme, die über das Halbleitersubstrat 1 und die Teile 18, 17, 16 nach Masse V_{SS} abfließen, so kann am Innenwiderstand W von 16 ein solcher Spannungsabfall entstehen, daß der Ausgang 17 und damit das Halbleitersubstrat 1 zumindest vorübergehend auf eine positive Vorspannung gelangt. In diesem Falle werden diese Ströme über die zusätzliche Klemmschaltung abgeführt.

Der Substratvorspannungsgenerator 16, die elektronische Schutzschaltung 27 sowie der Vorspannungsgenerator 28 für der Kondensator der Figuren 1 und 2 sind zweckmäßigerweise auf dem Halbleitersubstrat mit aufintegriert.

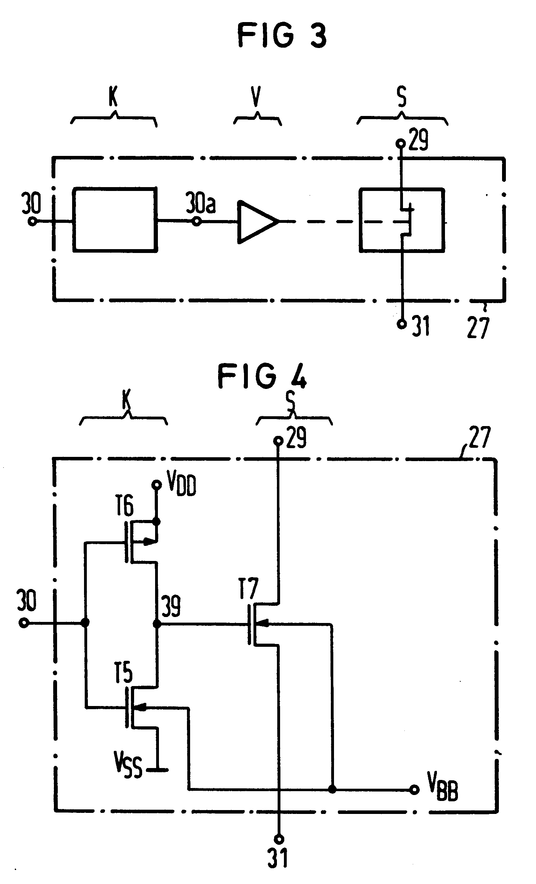

In Figur 3 ist eine Prinzipschaltung der elektronischen Schutzschaltung 27 angegeben. Sie besteht aus drei Einzelkomponenten, einem Komparator K mit einem Eingang 30, einem Verstärker V und einem elektronischen Schalter S mit einem Eingang 31 und einem Ausgang 29. Der Komparator vergleicht die am Eingang 30 anliegende Spannung mit einem intern vorgegebenen Spannungswert bzw. dem Massepotential V_{SS}. Fällt der Vergleich positiv aus, dies bedeutet, die anliegende Spannung ist größer als der interne Spannungswert, wird ein entsprechendes Signal an den Ausgang 30a abgegeben, das über den Verstärker V verstärkt wird und in dem elektronischen Schalter S den Eingang 31 und Ausgang 29 elektrisch voneinander trennt. Ist die anliegende Spannung am Eingang 30 jedoch kleiner als der interne Spannungswert, werden über ein Signal am Ausgang 30a der Eingang 31 und der Ausgang 29 im elektronischen Schalter S elektrisch miteinander verbunden. Der Verstärker V ist wahlweise einzubauen, je nach der erforderlichen Anpassung des Ausgangssignals des Komparators K an den elektronischen Schalter S.

Ein Ausführungsbeispiel für eine elektronische Schutzschaltung 27 ist in Figur 4 dargestellt. Sie besteht lediglich aus zwei Komponenten, einem Komparator K und einem elektronischen Schalter S. Für den Komparator K ist eine Serienschaltung eines n-Kanal-Feldeffekttransistors T5 und eines Lastelements vorgesehen, das insbesondere durch einen p-Kanal-Feldeffekttransistor T6 gebildet wird, dessen Substrat mit seinem Sourceanschluß verbunden ist. Die Gates der Feldeffekttransistoren T5 und T6 sind zusammengeschaltet und bilden den Eingang 30 der elektronischen Schutzschaltung 27. Der eine Anschluß der Serienschaltung ist auf die Versorgungsspannung V_{DD} gelegt, während der andere Anschluß mit der Masse V_{SS} verbunden ist. Der elektronische Schalter S ist durch einen n-Kanal-Feldeffekttransistor T7 realisiert. Drain- und Sourceanschluß bilden jeweils den Eingang 31 und den Ausgang 29 der elektronischen Schutzschaltung 27. Der Verbindungspunkt 39 ist an das Gate des n-Kanal-Feldeffekttransistors T7 angeschlossen, während der Substratanschluß des Feldeffekttransistors T7 und des Feldeffekttransistors T5 auf Substratpotential V_{BB} liegt.

Übersteigt im Betrieb die Spannung am Eingang 30 die Summe der Einsatzspannungen U_{T} des Feldeffekttransistors T5 und der Spannung V_{SS} Masse, so sinkt die Ausgangsspannung des Inverters T5, T6 ab. Der Feldeffekttransistor T5 wird leitend und erniedrigt das Spannungspotential am Verbindungspunkt 39. In diesem Falle sperrt der Feldeffekttransistor T7 und die Verbindung zwischen dem Eingang 31 und dem Ausgang 29 ist unterbrochen. Bei negativer Substratvorspannung, bei Spannungen also kleiner als U_{T} + V_{SS} sperrt der Feldeffekttransistor T5, während die Feldeffekttransistoren T6, T7 in den leitenden Zustand übergehen. In diesem Falle werden der Eingang 31 und der Ausgang 29 elektrisch miteinander verbunden. Weder die Versorgungsspannung V_{DD} noch die Substratvorspannung V_{BB} werden im Normalbetrieb mit Strom belastet.

Neben den oben behandelten Ausführungsformen umfaßt die Erfindung auch solche, bei denen n-leitendes Substrat mit p-leitenden wannenförmigen Halbleiterzonen versehen ist. Dabei werden die Leitungstypen sämtlicher Halbleiterteile und die Polaritäten sämtlicher Spannungen durch die jeweils entgegengesetzten ersetzt.

Weiterhin werden auch solche Ausführungsformen von der Erfindung erfaßt, die sich aus Figur 1 und Figur 2 durch folgende Abänderungen ergeben. Die Begrenzungslinie B1 fällt weg, wobei diese beiden Teile nunmehr als n-leitendes Substrat aufzufassen sind. Hiervon ausgehend wird dann in dieses n-leitende Substrat eine p-leitende wannenförmige Halbleiterzone eingefügt, die durch die gestrichelte Linie B2 gegen das n-leitende Substrat abgegrenzt ist und die Schaltungsteile T2, T3, C, T4 und 18 enthält.

Eine bevorzugte Anwendung der Erfindung ergibt sich für die Peripherieschaltungen von dynamischen Halbleiterspeichern großer Packungsdichte, die mit den Speicherzellen monolithisch integriert sind.

## Patentansprüche

1. Integrierte Schaltung in komplementärer Schaltungstechnik mit Feldeffekttransistoren (T1, T2) unterschiedlicher Kanaltypen, von denen wenigstens ein erster (T1) in einem p-leitenden Halbleitersubstrat (1) und wenigstens ein zweiter (T2) in einer im Halbleitersubstrat vorgesehenen n-leitenden wannenförmigen Halbleiterzone (2) angeordnet sind, wobei die Halbleiterzone (2) mit einer positiven Versorgungsspannung (V_{DD}) beschaltet ist, wobei ein Anschlußgebiet (3) wenigstens eines ersten Feldeffekttransistors (T1) mit einem Massepotential (V_{SS}) angeschlossen ist, wobei das Halbleitersubstrat (1) über einen Substratvorspannungsanschluß (18) mit dem Ausgang 17 eines eine negative Substratvorspannung erzeugenden Substratvorspannungsgenerators (16) verbunden ist, dem das Massepotential und die Versorgungsspannung zugeführt werden, **dadurch gekennzeichnet,** daß ein Kondensator (C) mit zwei Kondensatorflächen (24, 26) vorgesehen ist, dessen erste Kondensatorfläche (24) in dem Halbleitersubstrat (1) integriert ist und dessen zweite Kondensatorfläche (26) über eine elektronische Schutzschaltung (27) an einen Vorspannungsgenerator (28) für den Kondensator geschaltet wird, daß die Schutzschaltung eine Serienschaltung eines Lastelements und eines dritten, n-Kanal Feldeffekttransistors (T5) enthält, daß ein erster Anschluß dieser Serienschaltung, der zugleich einen Anschluß des Lastelements darstellt, mit der Versorgungsspannung (V_{DD}) beschaltet ist, daß der zweite Anschluß dieser Serienschaltung, der zugleich einen Anschluß des dritten Feldeffekttransistors (T5) darstellt, mit dem Massepotential (V_{SS}) belegt ist, daß ein Gateanschluß des dritten Feldeffekttransistors (T5), der den Eingang (30) der Schutzschaltung bildet, mit dem Substratvorspannungsanschluß (18) angeschlossen ist, daß bei einer am Substratvorspannungsanschluß (18) abgegriffenen Spannung, die größer als die Summe aus dem Massepotential (V_{SS}) und der Einsatzspannung U_{T} des dritten Feldeffekttransistors ist, die zweite Kondensatorfläche (26) und der Vorspannungsgenerator (28) für den Kondensator durch die elektronische Schutzschaltung (27) getrennt sind und daß bei einer am Substratvorspannungsanschluß (18) abgegriffenen Spannung, die kleiner als die obengenannte Summe ist, die zweite Kondensatorfläche (26) und der Vorspannungsgenerator (28) für den Kondensator durch die elektronische Schutzschaltung (27) miteinander verbunden sind.

2. Integrierte Schaltung nach Anspruch 1, **dadurch gekennzeichnet,** daß das Lastelement aus einem vierten p-Kanal-Feldeffekttransistor (T6) besteht und ein Gateanschluß des vierten Feldeffekttransistors mit dem Gateanschluß des dritten Feldeffekttransistors (T5) und ein Substratanschluß des vierten Feldeffekttransistors (16) mit dem ersten Anschluß (V_{DD}) der Serienschaltung verbunden ist.

3. Integrierte Schaltung nach Anspruch 1 oder 2, **dadurch gekennzeichnet,** daß die elektronische Schutzschaltung (27) einen fünften Feldeffekttransistor (T7) enthält, der mit einem Gateanschluß an einem Verbindungspunkt (39) des dritten Feldeffekttransistors (T5) und des Lastelements der Serienschaltung verbunden ist, daß ein Substratanschluß des fünften Feldeffekttransistors (T7) mit dem Ausgang (17) des Substratvorspannungsgenerators (16) verschaltet ist, daß ein Sourceanschluß des fünften Feldeffekttransistors (T7) mit der zweiten Kondensatorfläche (26) und ein Drainanschluß des fünften Feldeffekttransistors (T7) mit dem Vorspannungsgenerator (28) für den Kondensator verbunden ist.

4. Integrierte Schaltung nach einem der Ansprüche 1 bis 3, **dadurch gekennzeichnet,** daß der Ausgang (17) des Substratvorspannungsgenerators (16) über einen zusätzlichen n-Kanal Feldeffekttransistor (T4) mit einem auf Massepotential (V_{SS}) liegenden Schaltungspunkt (36) verbunden ist und daß der zusätzliche n-Kanal-Feldeffekttransistor (T4) über den Ausgang (17) des Substratvorspannungsgenerators (16) angesteuert wird.

5. Integrierte Schaltung nach einem der Ansprüche 1 bis 4, **dadurch gekennzeichnet,** daß der Substratvorspannungsgenerator (16), der Vorspannungsgenerator (28) für den Kondensator, die elektronische Schutzschaltung (27) und der zusätzliche n-Kanal-Feldeffekttransistor (T4) auf dem Halbleitersubstrat mit aufintegriert sind.

6. Integrierte Schaltung in komplementärer Schaltungstechnik mit Feldeffekttransistoren (T1, T2) unterschiedlicher Kanaltypen, von denen wenigstens ein erster (T1) in einem n-leitenden Halbleitersubstrat (1) und wenigstens ein zweiter (T2) in einer im Halbleitersubstrat vorgesehenen p-leitenden wannenförmigen Halbleiterzone (2) angeordnet sind, wobei das Halbleitersubstrat (1) mit einer positiven Versorgungsspannung (V_{DD}) beschaltet ist, wobei ein Anschlußgebiet (3) wenigstens eines ersten Feldeffekttransistors (T1) mit einem Massepotential (V_{SS}) angeschlossen ist, wobei die wannenförmige Halbleiterzone (2) mit dem Ausgang 17 eines eine negative Substratvorspannung erzeugenden Substratvorspannungsgenerators (16) verbunden ist, dem das Massepotential und die Versorgungsspannung zugeführt werden, **dadurch gekennzeichnet,** daß ein Kondensator (C) mit zwei Kondensatorflächen (24, 26) vorgesehen ist, dessen erste Kondensatorfläche (24) in die wannenförmige Halbleiterzone (2) integriert ist und dessen zweite Kondensatorfläche (26) über eine elektronische Schutzschaltung (27) an einen Vorspannungsgenerator (28) für den Kondensator geschaltet wird, daß die Schutzschaltung eine Serienschaltung eines Lastelements und eines dritten, n-Kanal Feldeffekttransistors (T5) enthält, daß ein erster Anschluß dieser Serienschaltung, der zugleich einen Anschluß des Lastelements darstellt, mit der Versorgungsspannung (V_{DD}) beschaltet ist, daß der zweite Anschluß dieser Serienschaltung, der zugleich einen Anschluß des dritten Feldeffekttransistors (T5) darstellt, mit dem Massepotential (V_{SS}) belegt ist, daß ein Gateanschluß des dritten Feldeffekttransistors (T5), der den Eingang (30) der Schutzschaltung bildet, mit dem Substratvorspannungsanschluß des Substrats angeschlossen ist, daß bei einer am Substratvorspannungsanschluß (18) abgegriffenen Spannung, die größer als die Summe aus dem Massepotential (V_{SS}) und der Einsatzspannung U_{T} des dritten Feldeffekttransistors ist, die zweite Kondensatorfläche (26) und der Vorspannungsgenerator (28) für den Kondensator durch die elektronische Schutzschaltung (27) getrennt sind und daß bei einer am Substratvorspannungsanschluß (18) abgegriffenen Spannung, die kleiner als die obengenannte Summe ist, die zweite Kondensatorfläche (26) und der Vorspannungsgenerator (28) für den Kondensator durch die elektronische Schutzschaltung (27) miteinander verbunden sind.

7. Integrierte Schaltung nach Anspruch 6, **dadurch gekennzeichnet,** daß das Lastelement aus einem vierten p-Kanal-Feldeffekttransistor (T6) besteht und ein Gateanschluß des vierten Feldeffekttransistors (T6) mit dem Gateanschluß des dritten Feldeffekttransistors (T5) und ein Substratanschluß des vierten Feldeffekttransistors (T5) mit dem ersten Anschluß (V_{DD}) der Serienschaltung verbunden ist.

8. Integrierte Schaltung nach Anspruch 6 oder 7, **dadurch gekennzeichnet,** daß die elektronische Schutzschaltung (27) einen fünften Feldeffekttransistor (T7) enthält, der mit einem Gateanschluß an einem Verbindungspunkt (39) des dritten Feldeffekttransistors (T5) und des Lastelements der Serienschaltung verbunden ist, daß ein Substratanschluß des fünften Feldeffekttransistors (T7) mit dem Ausgang (17) des Substratvorspannungsgenerators (16) verschaltet ist, daß ein Sourceanschluß des fünften Feldeffekttransistors (T7) mit der zweiten Kondensatorfläche (26) und ein Drainanschluß des fünften Feldeffekttransistors (T7) mit dem Vorspannungsgenerator (28) für den Kondensator verbunden ist.

9. Integrierte Schaltung nach einem der Ansprüche 6 bis 8, **dadurch gekennzeichnet,** daß der Ausgang (17) des Substratvorspannungsgenerators (16) über einen zusätzlichen n-Kanal-Feldeffekttransistor (T4) mit einem auf Massepotential (V_{SS}) liegenden Schaltungspunkt (36) verbunden ist und daß der zusätzliche n-Kanal-Feldeffekttransistor (T4) über den Ausgang (17) des Substratvorspannungsgenerators (16) angesteuert wird.

10. Integrierte Schaltung nach einem der Ansprüche 1 bis 7, **dadurch gekennzeichnet,** daß der Substratvorspannungsgenerator (16), der Vorspannungsgenerator (28) für den Kondensator, die elektronische Schutzschaltung (27) und der zusätzliche n-Kanal Feldeffekttransistor (T4) auf dem Halbleitersubstrat mit aufintegriert sind.

11. Integrierte Schaltung nach einem der vorhergehenden Ansprüche, **gekennzeichnet durch** die Anwendung als Peripherieschaltung für dynamische Halbleiterspeicher hoher Integrationsdichte.

## Claims

1. Integrated circuit using complementary circuit technology and comprising field-effect transistors (T1, T2) of different channel types, of which at least one first field-effect transistor (T1) is disposed in a p-type semiconductor substrate (1) and at least one second field-effect transistor (T2) is disposed in an n-type well-shaped semiconductor zone (2) provided in the semiconductor substrate, the semiconductor zone (2) being connected to a positive supply voltage (V_{DD}), a terminal region (3) of at least one first field-effect transistor (T1) being connected to an earth potential (V_{SS}), and the semiconductor substrate (1) being connected via a substrate bias terminal (18) to the output (17) of a substrate bias generator (16) which generates a negative substrate bias and to which the earth potential and the supply voltage are fed, characterised in that a capacitor (C) is provided with two capacitor surfaces (24, 26), its first capacitor surface (24) being integrated in the semiconductor substrate (1) and its second capacitor surface (26) being connected via an electronic protection circuit (27) to a capacitor bias generator (28), in that the protection circuit contains a series circuit of a load element and a third, n-channel field-effect transistor (T5), in that a first terminal of said series circuit, which is also a terminal of the load element, is connected to the supply voltage (V_{DD}), in that the second terminal of said series circuit, which is also a terminal of the third field-effect transistor (T5) is assigned to the earth potential (V_{SS}), in that a gate terminal of the third field-effect transistor (T5), which forms the protection circuit input (30) is connected to the substrate bias terminal (18), in that, at a voltage tapped off at the substrate bias terminal (18) and greater than the sum of the earth potential (V_{SS}) and the turn-on voltage U_{T} of the third field-effect transistor, the second capacitor surface (26) and the capacitor bias generator (28) are isolated by the electronic protection circuit, and in that, at a voltage tapped off at the substrate bias terminal (18) and less than the above-mentioned sum, the second capacitor surface (26) and the capacitor bias generator (28) are interconnected by the electronic protection circuit (27).

2. Integrated circuit according to Claim 1, characterised in that the load element comprises a fourth p-channel field-effect transistor (T6) and a gate terminal of the fourth field-effect transistor is connected to the gate terminal of the third field-effect transistor (T5) and a substrate terminal of the fourth field-effect transistor (T6) is connected to the first terminal (V_{DD}) of the series circuit.

3. Integrated circuit according to Claim 1 or 2, characterised in that the electronic protection circuit (27) contains a fifth field-effect transistor (T7) which is connected by means of a gate terminal to an interconnection point (39) of the third field-effect transistor (T5) and of the load element of the series circuit, in that a substrate terminal of the fifth field-effect transistor (T7) is connected to the output (17) of the substrate bias generator (16), and in that a source terminal of the fifth field-effect transistor (T7) is connected to the second capacitor surface (26) and a drain terminal of the fifth field-effect transistor (T7) is connected to the capacitor bias generator (28).

4. Integrated circuit according to one of Claims 1 to 3, characterised in that the output (17) of the substrate bias generator (16) is connected via an additional n-channel field-effect transistor (T4) to a circuit point (36) which is at earth potential (V_{SS}) and in that the additional n-channel field-effect transistor (T4) is triggered via the output (17) of the substrate bias generator (16).

5. Integrated circuit according to one of Claims 1 to 4, characterised in that the substrate bias generator (16), the capacitor bias generator (28), the electronic protection circuit (27) and the additional n-channel field-effect transistor (T4) are conjointly integrated on the semiconductor substrate.

6. Integrated circuit using complementary circuit technology and comprising field-effect transistors (T1, T2) of different channel types, of which at least one first field-effect transistor (T1) is disposed in an n-type semiconductor substrate (1) and at least one second field-effect transistor (T2) is disposed in a p-type well-shaped semiconductor zone (2) provided in the semiconductor substrate, the semiconductor substrate (1) being connected to a positive supply voltage (V_{DD}), a terminal region (3) of at least a first field-effect transistor (T1) being connected to an earth potential (V_{SS}), and the well-shaped semiconductor zone (2) being connected to the output (17) of a substrate bias generator (16) which generates a negative substrate bias and to which the earth potential and the supply voltage are fed, characterised in that a capacitor (C) is provided with two capacitor surfaces (24, 26), its first capacitor surface (24) being integrated in the well-shaped semi-conductor zone (2) and its second capacitor surface (26) being connected via an electronic protection circuit (27) to a capacitor bias generator (28), in that the protection circuit contains a series circuit of a load element and a third, n-channel field-effect transistor (T5), in that a first terminal of said series circuit, which is also a terminal of the load element, is connected to the supply voltage (V_{DD}), in that the second terminal of said series circuit, which is also a terminal of the third field-effect transistor (T5) is assigned to the earth potential (V_{SS}), in that a gate terminal of the third field-effect transistor (T5), which forms the protection circuit input (30), is connected to the substrate bias terminal of the substrate, in that, at a voltage tapped off at the substrate bias terminal (18) and greater than the sum of the earth potential (V_{SS}) and the turn-on voltage U_{T} of the third field-effect transistor, the second capacitor surface (26) and the capacitor bias generator (28) are isolated by the electronic protection circuit and in that, at a voltage tapped off at the substrate bias terminal (18) and less than the abovementioned sum, the second capacitor surface (26) and the capacitor bias generator (28) are interconnected by the electronic protection circuit (27).

7. Integrated circuit according to Claim 6, characterised in that the load element comprises a fourth p-channel field-effect transistor (T6) and a gate terminal of the fourth field-effect transistor (T6) is connected to the gate terminal of the third field-effect transistor (T5) and a substrate terminal of the fourth field-effect transistor (T5) is connected to the first terminal (V_{DD}) of the series circuit.

8. Integrated circuit according to Claim 6 or 7, characterised in that the electronic protection circuit (27) contains a fifth field-effect transistor (T7) which is connected by means of a gate terminal to an interconnection point (39) of the third field-effect transistor (T5) and of the load element of the series circuit, in that a substrate terminal of the fifth field-effect transistor (T7) is connected to the output (17) of the substrate bias generator (16), and in that a source terminal of the fifth field-effect transistor (T7) is connected to the second capacitor surface (26) and a drain terminal of the fifth field-effect transistor (T7) is connected to the capacitor bias generator (28).

9. Integrated circuit according to one of Claims 6 to 8, characterised in that the output (17) of the substrate bias generator (16) is connected via an additional n-channel field-effect transistor (T4) to a circuit point (36) which is at earth potential (V_{SS}), and in that the additional n-channel field-effect transistor (T4) is triggered via the output (17) of the substrate bias generator (16).

10. Integrated circuit according to one of Claims 1 to 7, characterised in that the substrate bias generator (16), the capacitor bias generator (28), the electronic protection circuit (27) and the additional n-channel field-effect transistor (T4) are conjointly integrated on the semiconductor substrate.

11. Integrated circuit according to one of the preceding claims, characterised by the application as peripheral circuit for dynamic semiconductor memories with high integration density.

## Revendications

1. Circuit intégré dans une technologie de circuit complémentaire comportant des transistors à effet de champ (T1, T2) de différents types de canal, parmi lesquels au moins un premier transistor à effet de champ (T1) est disposé dans un substrat semiconducteur (1) de conductivité p et au moins un deuxième transistor à effet de champ (T2) est disposé dans une zone à semiconducteur (2) en forme de cuvette et de conductivité n, prévue dans le substrat semiconducteur, du type dans lequel la zone à semiconducteur (2) est portée à une tension d'alimentation positive (V_{DD}), une zone de connexion (3) au moins d'un premier transistor à effet de champ (T1) est reliée à un potentiel de masse (V_{SS}), le substrat à semiconducteur (1) est relié par l'intermédiaire d'une borne (18) de la tension de polarisation du substrat, à la sortie (17) d'un générateur (16) de tension de polarisation du substrat, qui crée une tension négative de polarisation du substrat et auquel sont envoyé le potentiel de masse et la tension d'alimentation caractérisé en ce qu'il est prévu un condensateur (C) comportant deux faces (24, 26) de condensateur, dont la première face (24) de condensateur est intégrée dans le substrat à semiconducteur (1) et dont la seconde face (26) de condensateur est connectée, par l'intermédiaire d'un circuit électronique de protection (27), à un générateur (28) de tension de polarisation pour le condensateur, en ce que le circuit de protection comprend un circuit série d'un élément de charge et d'un troisième transistor à effet de champ (T5) à canal n, en ce qu'une première borne de ce circuit série, qui représente en même temps une borne de l'élément de charge, est reliée à la tension d'alimentation (V_{DD}), en ce que la deuxième borne de ce circuit série, qui représente en même temps une borne du troisième transistor à effet de champ (T5), est mise au potentiel de masse (V_{SS}), en ce qu'une borne de grille du troisième transistor à effet de champ (T5), qui forme l'entrée (30) du circuit de protection, est reliée à la borne (18) de la tension de polarisation du substrat, en ce que, pour une tension prélevée à la borne (18) de la tension de polarisation du substrat, qui est supérieure à la somme du potentiel de masse (V_{SS}) et de la tension de coupure U_{T} du troisième transistor à effet de champ, la seconde face (26) du condensateur et le générateur (28) de tension de polarisation pour le condensateur sont déconnectés par l'intermédiaire du circuit électronique de protection (27) et en ce que, pour une tension prélevée a la borne (18) de la tension de polarisation du substrat, qui est inférieure à la somme précédemment citée, la seconde face (26) du condensateur et le générateur (28) de tension de polarisation pour le condensateur sont reliés ensemble par l'intermédiaire du circuit électronique de protection (27).

2. Circuit intégré selon la revendication 1, caractérisé en ce que l'élément de charge se compose d'un quatrième transistor à effet de champ (T6) à canal p et une borne de grille du quatrième transistor à effet de champ (T6) est reliée à la borne de grille du troisième transistor à effet de champ (T5) et une borne de substrat du quatrième transistor à effet de champ (T6) est reliée à la première borne (V_{DD}) du circuit série.

3. Circuit intégré selon la revendication 1 ou 2, caractérisé en ce que le circuit électronique de protection (27) comprend un cinquième transistor à effet de champ (T7), qui est relié par une borne de grille en un point de connexion (39) du troisième transistor à effet de champ (T5) et de l'élément de charge du circuit série, en ce qu'une borne de substrat du cinquième transistor à effet de champ (T7) est connectée à la sortie (17) du générateur (16) de tension de polarisation du substrat, en ce qu'une borne de source du cinquième transistor à effet de champ (T7) est reliée à la seconde face (26) du condensateur, et une borne de drain du cinquième transistor à effet de champ (T7) est reliée au générateur (28) de tension de polarisation pour le condensateur.

4. Circuit intégré selon l'une des revendications 1 à 3, caractérisé en ce que la sortie (17) du générateur (16) de tension de polarisation du substrat est reliée, par l'intermédiaire d'un transistor à effet de champ (T4) supplémentaire à canal n, à un point du câblage (36) placé au potentiel de masse (V_{SS}), et en ce que le transistor à effet de champ supplémentaire (T4) à canal n est commandé par la sortie (17) du générateur (16) de tension de polarisation du substrat.

5. Circuit intégré selon l'une des revendications 1 à 4, caractérisé en ce que le générateur (16) de tension de polarisation du substrat, le générateur (28) de tension de polarisation pour le condensateur, le circuit électronique de protection (27) et le transistor à effet de champ supplémentaire (T4) à canal n sont intégrés dans le substrat à semiconducteur.

6. Circuit intégré dans une technique de circuit complémentaire comportant des transistors à effet de champ (T1, T2) de différents types de canal, parmi lesquels au moins un premier transistor à effet de champ (T1) est disposé sur un substrat à semiconducteur (1) de conductivité n et au moins un deuxième transistor à effet de champ (T2) est disposé dans une zone à semiconducteur (2) en forme de cuvette et de conductivité p prévue dans le substrat à semiconducteur, du type dans lequel le substrat à semiconducteur (1) est porté à une tension d'alimentation (V_{DD}) positive, une zone de connexion (3) au moins d'un premier transistor à effet de champ (T1) est reliée à un potentiel de masse (V_{SS}), la zone à semiconducteur (2) en forme de cuvette est reliée à la sortie (17) d'un générateur (16) de tension de polarisation du substrat, qui crée une tension négative de polarisation du substrat, et auquel sont envoyés le potentiel de masse et la tension d'alimentation caractérisé en ce qu'il est prévu un condensateur (C) comportant deux faces (24, 26) de condensateur, dont la première face (24) de condensateur est intégrée dans la zone à semiconducteur (2) en forme de cuvette et dont la seconde face (26) de condensateur est connectée à un générateur (28) de tension de polarisation pour le condensateur , par l'intermédiaire d'un circuit électronique de protection (27), en ce que le circuit de protection comprend un circuit série d'un élément de charge et d'un troisième transistor à effet de champ (T5) à canal n, en ce qu'une première borne de ce circuit série, qui représente en même temps une borne de l'élément de charge, est connectée à la tension d'alimentation (V_{DD}), en ce que la deuxième borne de ce circuit série, qui représente en même temps une borne du troisième transistor à effet de champ (T5), est mise au potentiel de masse (V_{SS}), en ce qu'une borne de grille du troisième transistor à effet de champ (T5), qui forme l'entrée (30) du circuit de protection, est reliée à la borne (18) de la tension de polarisation du substrat, en ce que, pour une tension prélevée à la borne (18) de la tension de polarisation du substrat, qui est supérieure à la somme du potentiel de masse (V_{SS}) et de la tension de coupure U_{T} du troisième transistor à effet de champ, la seconde face (26) du condensateur et le générateur (28) de tension de polarisation pour le condensateur sent déconnectés par l'intermédiaire du circuit électronique de protection (27) et en ce que, pour une tension prélevée à la borne (18) de tension de polarisation de substrat, qui est inférieure à la somme précédemment citée, la seconde face (26) du condensateur et le générateur (28) de tension de polarisation pour le condensateur sont reliés, ensemble, par l'intermédiaire du circuit électronique de protection (27).

7. Circuit intégré selon la revendication 6, caractérisé en ce que l'élément de charge se compose d'un quatrième transistor à effet de champ (T6) à canal p et une borne de grille du quatrième transistor à effet de champ (T6) est reliée à la borne de grille du troisième transistor à effet de champ (T5) et une borne de substrat du quatrième transistor à effet de champ (T6) est reliée à la première borne (V_{DD}) du circuit série.

8. Circuit intégré selon la revendication 6 ou 7, caractérisé en ce que le circuit électronique de protection (27) comprend un cinquième transistor à effet de champ (T7), qui est relié à une borne de grille en un point de connexion (39) du troisième transistor à effet de champ (T5) et de l'élément de charge du circuit série, en ce qu'une borne de substrat du cinquième transistor à effet de champ (T7) est connectée à la sortie (17) du générateur (16) de tension de polarisation du substrat, en ce qu'une borne de source du cinquième transistor à effet de champ (17) est reliée à la seconde face (26) du condensateur et une borne de drain du cinquième transistor à effet de champ (T7) est reliée au générateur (28) de tension de polarisation pour le condensateur.

9. Circuit intégré selon l'une quelconque des revendications 6 à 8, caractérisé en ce que la sortie (17) du générateur (16) de tension de polarisation du substrat est reliée à un point du câblage (36) placé au potentiel de masse (V_{SS}) par l'intermédiaire d'un transistor à effet de champ (T4) supplémentaire à canal n et en ce que le transistor à effet de champ (T4) supplémentaire à canal n est commandé par la sortie (17) du générateur (16) de tension de polarisation du substrat.

10. Circuit intégré selon l'une des revendications 1 à 7, caractérisé en ce que le générateur (16) de tension de polarisation du substrat, le générateur (28) de tension de polarisation pour le condensateur, le circuit électronique de protection (27) et le transistor à effet de champ (T4) supplémentaire à canal n sont intégrés dans le substrat à semiconducteur.

11. Circuit intégré selon l'une des revendications précédentes, caractérisé en ce qu'il est utilisé comme circuit périphérique pour des mémoires dynamiques à semiconducteurs à grande densité d'intégration.
